# EUROPEAN PATENT APPLICATION

(11) **EP 0 706 114 A2**
(43) Date of publication of application: **10.04.1996**
(21) Application number: 95306933.3
(22) Date of filing: 29.09.1995
(51) Int. Cl.: G06F 3/16

(54) **Apparatus and method for recording and organizing audio data**

(30) Priority: 03.10.1994 US 317404
(71) Applicant: AT&T GLOBAL INFORMATION SOLUTIONS INTERNATIONAL INC., Dayton, Ohio 45479 (US)
(72) Inventor: Margro, James R., Easley, SC 29657 (US)
(74) Representative: Robinson, Robert George

(57) **Abstract**

The invention relates to a method of and apparatus for recording and organizing audio data. The method includes the steps of: providing an audio data recorder (14) having a first interface (18), providing a computer (10) having a second interface (42), connecting the first interface (18) of the recorder (14) to the second interface (42) of the computer (10), downloading configuration data from the computer (10) to the recorder (14), and disconnecting the first interface (18) from the second interface (42) so that the recorder (14) is remote from the computer (10). The method further includes the steps of recording audio data in the recorder (14) in response to sensing a sound message, reconnecting the first interface (18) of the recorder (14) to the second interface (42) of the computer (10), and uploading audio data from the recorder (14) to the computer (10).

## Description

The present invention relates generally to devices and methods for recording audio data, and more particularly to devices and method for recording and organizing audio data.

Audio data recorders have existed for many years. One type of audio data recorder utilizes a magnetic tape to store recorded audio data thereon. The magnetic tape is contained in a cassette or cartridge with the tape wound around one reel and passing to another.

Another device which records audio data is a telephone answering machine. Certain telephone answering machines convert an audio message into digital data which is then stored in a memory. The recorded audio message can then be played back at the convenience of the user.

The type of audio data recorder which utilizes a magnetic tape to store recorded audio data thereon usually requires the user to playback various segments of the tape in order to locate a specific segment desired to be heard. This results in wasted time for the user.

Moreover, a user of a recorder utilizing magnetic tape may find it appropriate to record audio data on only a portion of the tape (e.g. 35%). This is true since the subject matter or author of a second audio message being recorded may change, and the user may find it desirable to record the second message on a second magnetic tape (e.g. for categorization purposes). This results in inefficient use of the recording medium, and necessitates an increase in the required physical storage space for the cassette tapes.

The types of audio data recorders discussed above do not take advantage of many of the beneficial data organizing capabilities of a computer.

It is therefore an object of the present invention to provide a new and useful method and apparatus for recording and organizing audio data.

According to a first aspect of the present invention there is provided a method of recording and organizing audio data, characterized by the steps of: providing an audio data recorder having a first interface; providing a computer having a second interface; connecting the first interface of the recorder to the second interface of the computer; downloading configuration data from the computer to the recorder; disconnecting the first interface from the second interface so that the recorder is remote from the computer; recording audio data in the recorder in response to sensing a sound message; reconnecting the first interface of the recorder to the second interface of the computer; and uploading audio data from the recorder to the computer.

According to a second aspect of the present invention there is provided an apparatus for recording and organizing audio data, characterized by: an audio data recorder having a first interface; and a computer having a second interface which interfaces with the first interface so as to allow audio data to be transferred between said recorder and said computer.

An embodiment of the present invention will now be described, by way of example, with reference to the accompanying drawing, in which:
FIG. 1 is a perspective view of an apparatus for recording and organizing audio data that incorporates the features of the present invention therein;
FIG. 2 is a hardware architecture block diagram of the recorder of the apparatus for recording and organizing audio data of FIG. 1;
FIG. 3 is a hardware architecture block diagram block diagram of the computer of the apparatus for recording and organizing audio data of FIG. 1, with the recorder of FIG. 2 depicted to generally show how it interfaces with the computer;
FIG. 4 is a software architecture block diagram block diagram of the computer of the apparatus for recording and organizing audio data of FIG. 1, with the recorder of FIG. 2 depicted to generally show how it interfaces with the computer; and
FIGS. 5 and 6 depict a screen of an application program of the present invention executing on the computer of FIG.3.

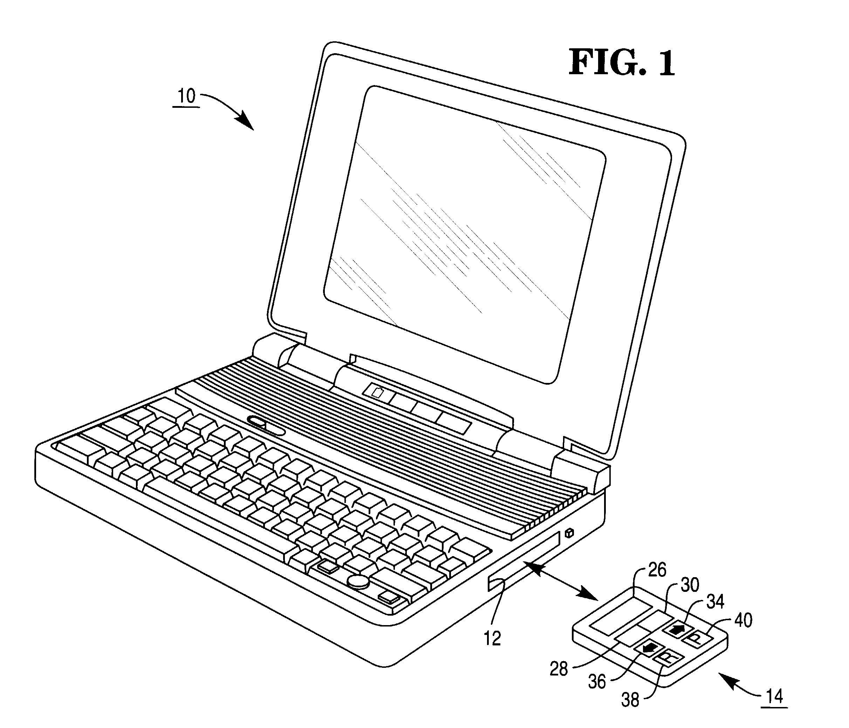

Referring now to FIG. 1, there is shown a notebook computer 10 and an audio data recorder 14. The computer 10 includes an input/output slot 12 for receiving the recorder 14. The recorder has a form factor of a PCMCIA type I, II, III or IV adapter card. PCMCIA is an acronym for "Personal Computer Memory Card International Association" and the standards associated therewith are well known in the art. The input/output slot 12 is configured to allow receipt of devices having a form factor of such a PCMCIA adapter card.

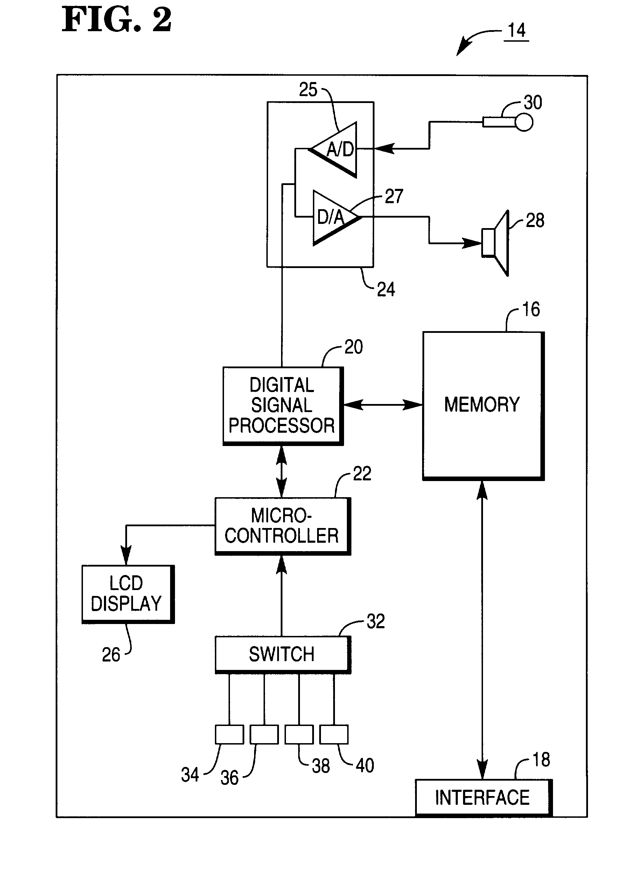

The recorder 14 is shown in more detail in FIG. 2. In particular, the recorder includes a memory 16, an interface 18, a digital signal processor 20, a micro-controller 22, an audio codec circuit 24, an LCD display 26, a speaker 28, a microphone 30, and a switch 32.

The memory 16 is a non-volatile memory such as a flash memory. The storage capacity of the memory 16 is at least 20 megabyte. The memory 16 is connected to the digital signal processor 20. The digital signal processor runs software algorithms for compressing and decompressing digital data. The memory 16 is also connected to the interface 18. The interface 18 is a PCMCIA interface (i.e. possesses characteristics consistent with the PCMCIA standard).

The audio codec circuit 24 is connected to the digital signal processor 20. The audio codec circuit includes an analog-to-digital (A/D) converter 25 and a digital-to-analog (D/A) converter 27. The microphone 30 is connected to the A/D converter 25 while the speaker 28 is connected to the D/A converter 27.

The microcontroller 22 is connected to the digital signal processor 20. The microcontroller is also connected to the LCD display 26 and the switch 32. The microcontroller controls the LCD display 26 as well as receives input signals from the switch 32. The switch 32 is a push-button debounce switch having four input buttons 34, 36, 38 and 40. Input button 34 is an increment index button and input button 36 is a decrement index button. Further, input button 38 is a record button while input button 40 is a playback button.

In operation, when a user desires to record a first segment of audio data, the user depresses the record button 38 which causes the microphone 30 to sense a sound message. For example, the sound message may be created by the user speaking into the microphone. The sound message is then converted by the microphone 30 into analog data. The analog data is then input to the A/D converter 25 of the audio codec circuit 24 and converted into digital data. The digital data is then input to the digital signal processor 20 where it is compressed by the digital signal processor running data compression software so as to form compressed digital data. The compressed digital data is then stored in the memory 16, and a number, for example, "1" is then displayed on the LCD display 26. This displayed number is now associated with the sound message which was recorded in the recorder 14.

When it is desired to playback the recorded sound message associated with the number "1", the user depresses the playback button 40 while the number "1" is displayed on the LCD display 26. This causes the compressed digital data which was stored in memory 16 to be input to the digital signal processor 20 where the digital signal processor, running data de-compression software, generates output digital data. The output digital data is then input to the D/A converter 27 of the codec circuit 24 and converted into output analog data. The output analog data is then input to the speaker 28. The speaker then generates sound corresponding to the recorded audio message associated with the number "1" displayed on the LCD display 26.

When a user desires to record a second segment of audio data, the user again depresses the record button 38 which causes the microphone 30 to sense a second sound message. The second segment of audio data is stored as compressed digital data in the memory 16 in a manner similar to the first segment of audio data. Another number, for example, "2" is then displayed on the LCD display 26. This displayed number is now associated with the second recorded sound message. Additional segments of audio data may be recorded in the memory 16 in a similar manner, and correspondingly, additional numbers (e.g. 3, 4, 5, etc.) become respectively associated with the additional recorded segments of audio data for display on the LCD display 26.

The user may select for playback between the recorded segments of audio data by depressing the increment index button 34 or the decrement index button 36. By depressing the increment index button 34, the number displayed on the LCD display 26 changes from "1" to "2", then "2" to "3", and so on. Similarly, by depressing the decrement index button 36, the number displayed on the LCD display 26 changes from "4" to "3", then "3" to "2", and so on. Once the desired recorded segment of audio data is selected (e.g. "2"), such segment of audio data may be played back by depressing the playback button 40.

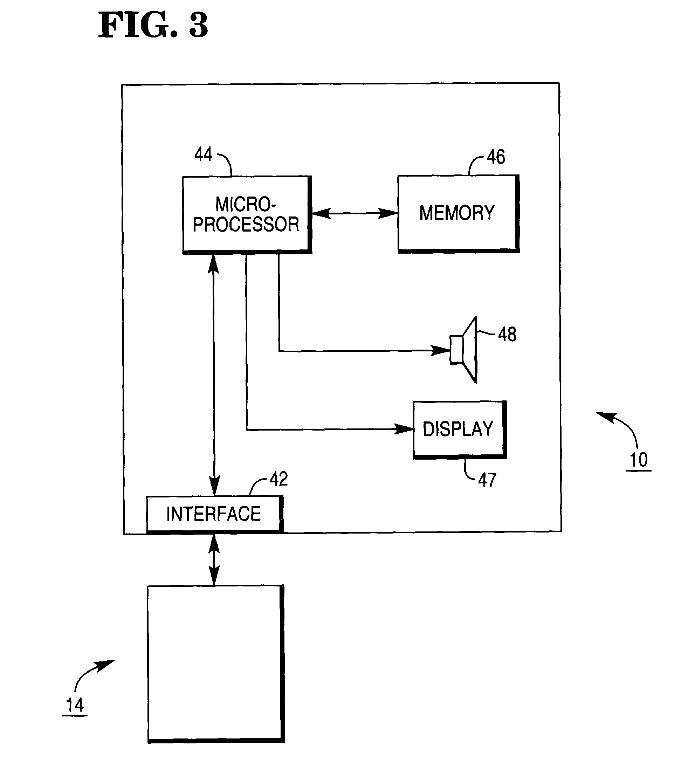

Referring now to FIG. 3, the computer 10 includes an interface 42, a microprocessor 44, a memory 46, a display 47 and a speaker 48. The interface 42, the memory 46, the display 47 and the speaker 48 are each connected to the microprocessor 44.

The interface 42 is a PCMCIA interface (i.e. possesses characteristics consistent with the PCMCIA standard). The interface 42 is adapted to be interfaced or connected to the interface 18 of the recorder 14 so that data can be transferred between the computer 10 and the recorder 14.

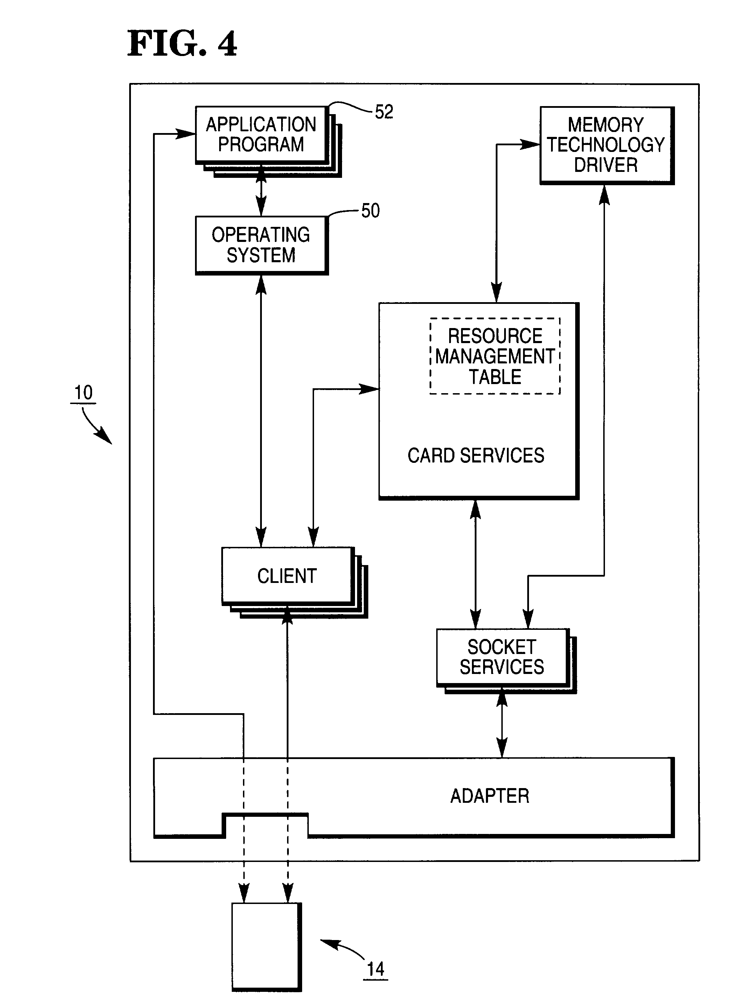

FIG. 4 depicts a software architecture diagram of the computer 10. The computer 10 operates under the control of an operating system 50, such as MS-DOS or any other conventionally known operating system. The operating system in turn may execute a Microsoft® Windows program or other user interface program for providing application programs to a user.

An application program 52 executing on the computer 10 downloads configuration data from the computer 10 to the recorder 14. The application program 52 also uploads digital data corresponding to recorded audio data from the recorder 14 to the computer 10. As used herein the term "downloads" or "uploads" means "transfers or copies". The term "downloads" is used herein when data is transferred or copied from the computer 10 to the recorder 14. The term "uploads" is used herein when the data is transferred or copied from the recorder 14 to the computer 10.

In operation, the recorder 14 is interfaced with the computer 10 (i.e. the interface 18 of the recorder 14 is connected to the interface 42 of the computer 10). Configuration data is then downloaded from the computer 10 to the recorder 14. One type of configuration data which may be downloaded corresponds to audio sample rate. The audio sample rate may be altered to decrease the amount of memory required for storage of a certain segment of audio data in the recorder 14. However, this will cause a corresponding decrease in the clarity of the sound during message playback.

Thereafter, the interface 18 of the recorder 14 is disconnected from the interface 42 of the computer 10 so that the recorder is located remote from the computer 10.

A first segment of audio data corresponding to a first sound message is then recorded in the memory 16 of the recorder 14 as hereinbefore described. A number "1" is displayed on the LCD display 26 of the recorder 14 in order to identify the first sound message. The first sound message is then played back by depressing the playback button 40 while the number "1" is displayed on the LCD display 26 as hereinbefore described.

Next, a second segment of audio data corresponding to a second sound message is recorded in the memory 16 of the recorder 14. A number "2" is then displayed on the LCD display 26 of the recorder 14 in order to identify the second sound message. Thereafter, a third segment of audio data corresponding to a third sound message is recorded in the memory 16 of the recorder 14, and a number "3" is displayed on the LCD display of the recorder in order to identify the third sound message.

The interface 18 of the recorder 14 is then reconnected to the interface 42 of the computer 10. Thereafter, audio data is uploaded from the recorder 14 to the computer 10. In particular, the application program 52 executing on the computer 10 causes compressed digital data to be read from the memory 16 of the recorder 14 to the memory 46 of the computer 10. The application program 52 then assembles the compressed digital data in the memory 46 of the computer 10 into separate files corresponding to separate recorded sound messages.

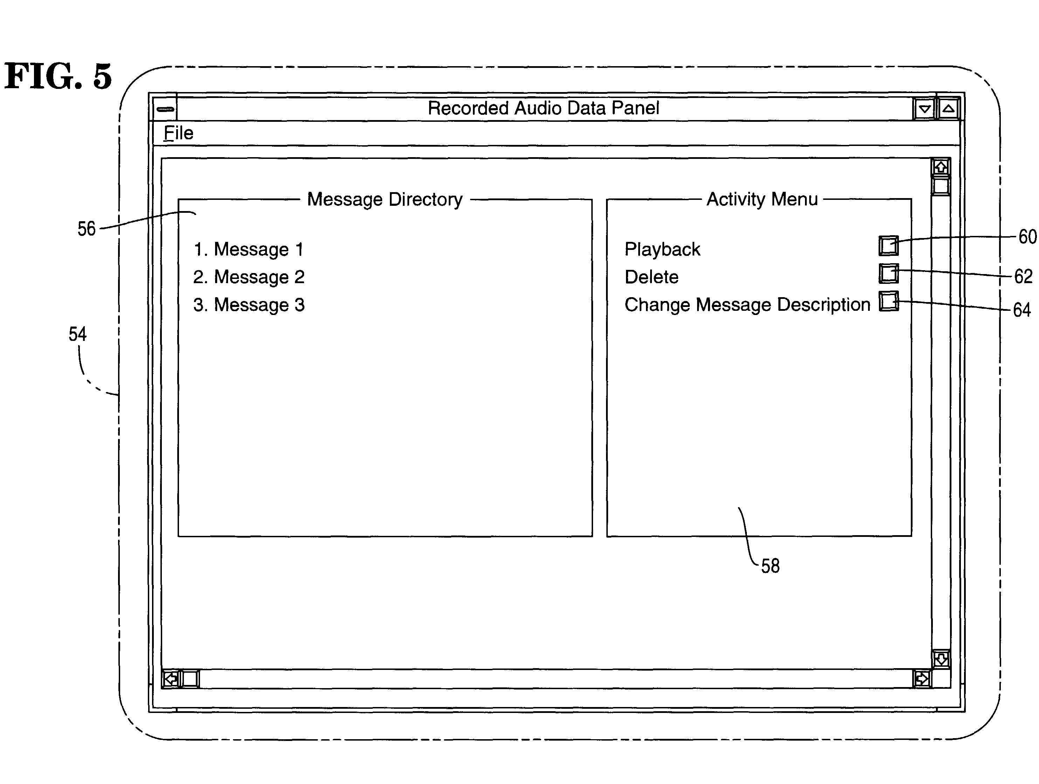

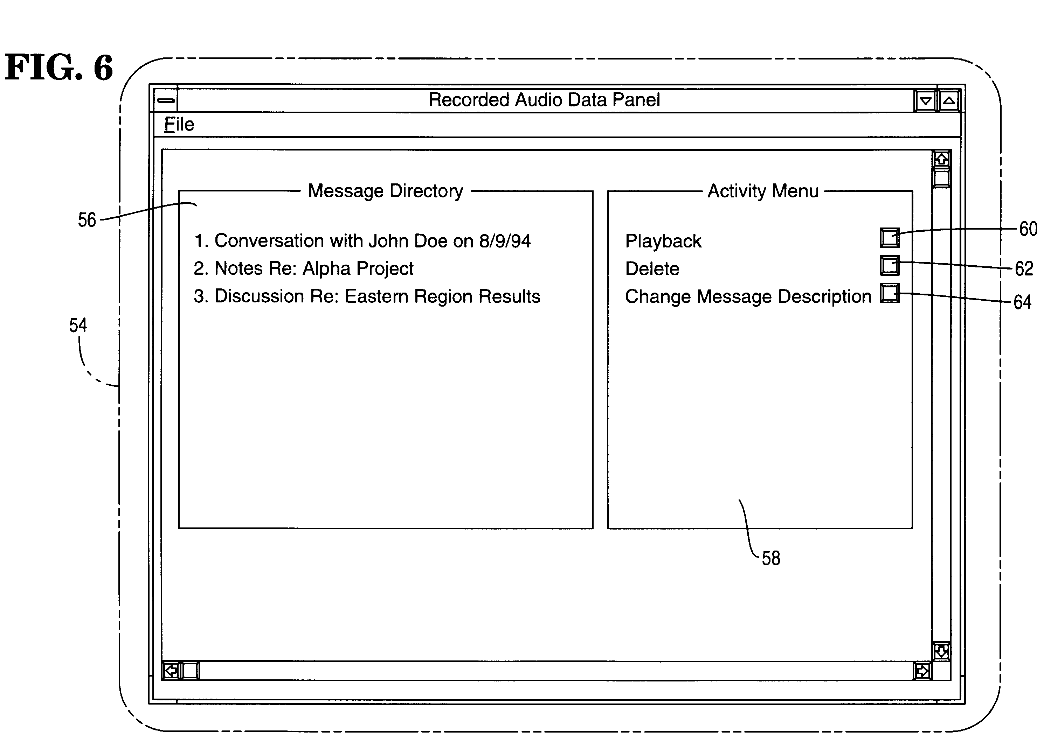

A screen 54 associated with the application program 52 is able to be displayed on the display 47 of the computer 10. The screen 54 is shown in FIGS. 5 and 6. The screen 54 includes a message directory panel 56 which lists the sound messages which have been recorded by the recorder 14 and uploaded to the computer 10. For example, FIG. 5 shows the screen 54 listing three separate files in the message directory panel 56.

The screen 54 further includes an activity menu panel 58 which indicates a variety of different activities which may be performed relative to any one of the entries listed in the message directory panel 56. One activity is associated with each of the following screen areas: "playback" area 60, "delete" area 62 and "change message description" area 64.

With the "playback" area 60, a user may playback a recorded sound message associated with one of the entries listed in the message directory panel 56. More specifically, one of the entries in the message directory panel is selected by performing a mouse click thereon, e.g. entry number "1" in FIG. 6 entitled "Conversation with John Doe on 8/9/94". Then, by clicking in the "playback" area 60 of the activity menu panel 58, the recorded sound message will be played back through the speaker 48 of the computer 10. Note that the computer 10 includes software capable of converting compressed digital data that is stored in the memory 46 into analog data which is then input to the speaker 48.

With the "delete" area 62, the user may delete from the memory 46 a recorded sound message associated with one of the entries listed in the message directory panel 56. Additionally, the "delete" area 62 can be used to delete a recorded sound message from the memory 16 of the recorder 14. Assuming again that entry number "1" entitled "Conversation with John Doe on 8/9/94" (see FIG. 6) has been selected by a mouse click in the message directory panel 56, the user may delete from the memory 46 the recorded sound message associated with the entry "1" by clicking in the "delete" area 62 of the activity menu panel 58. Once deleted from the memory 46, the entry associated with the deleted recorded sound message will no longer appear in the message directory panel 56.

With the "Change Message Description" area 64, the user may change the description of an entry listed in the message directory panel 56 to better describe the subject matter of the recorded sound message associated with such entry. For example, entry number "1" of the message directory panel 56 entitled "Message 1" (as shown in FIG. 5) can be changed to the entry "Conversation with John Doe on 8/9/94" (as shown in FIG. 6). Assuming that entry number "1" entitled "Message 1" (see FIG. 5) has been selected by an appropriate mouse click in the message directory panel 56, the user may change the message description by (1) clicking on the "Change Message Description" area 64 of the activity menu panel 58, (2) typing a new description on a keyboard of the computer 10, i.e. "Conversation with John Doe on 8/9/94", and (3) clicking again on the "Change Message Description" area 64.

## Claims

1. A method of recording and organizing audio data, characterized by the steps of: providing an audio data recorder (14) having a first interface (18); providing a computer (10) having a second interface (42); connecting the first interface (18) of the recorder to the second interface (42) of the computer (10); downloading configuration data from the computer (10) to the recorder (14); disconnecting the first interface (18) from the second interface (42) so that the recorder (14) is remote from the computer (10); recording audio data in the recorder (14) in response to sensing a sound message; reconnecting the first interface (18) of the recorder (14) to the second interface (42) of the computer (10); and uploading audio data from the recorder (14) to the computer (10).

2. A method according to claim 1, characterized by the step of providing the recorder (14) with a microphone (30), an analog-to-digital (A/D) converter circuit (25), a digital signal processor (20), and a first memory (16), and wherein the recording step comprises the steps of: generating analog data with the microphone (30) in response to sensing the sound message; converting the analog data into digital data with the A/D converter circuit (25); compressing the digital data with the digital signal processor (20) to form compressed digital data; and storing the compressed digital data in the first memory (16).

3. A method according to claim 2, characterized by the step of providing the computer (10) with a second memory (46), and wherein the uploading step comprises the step of: reading the compressed digital data from the first memory (16) of the recorder (14) into the second memory (46) of the computer (10).

4. A method according to claim 3, characterized by the step of creating a data file in the computer (10) to identify the contents of the compressed digital data in the second memory(46).

5. A method according to anyone of the preceding claims, characterized by the steps of: providing the recorder (14) with a first speaker (28); playing back the sound message with the first speaker (28) after the recording step; providing the computer (10) with a second speaker (48); and playing back the sound message with the second speaker (48) after the uploading step.

6. An apparatus for recording and organizing audio data, characterized by: an audio data recorder (14) having a first interface (18); and a computer (10) having a second interface (42) which interfaces with the first interface (18) so as to allow audio data to be transferred between said recorder (14) and said computer (10).

7. An apparatus according to claim 6, characterized by said recorder (14) comprising: means (30) for generating input analog data in response to sensing sound; means (25), connected to said input analog data generating means (30), for converting the input analog data into input digital data; means(20), connected to said converting means(25), for compressing the input digital data so as to generate compressed digital data; and a first memory (16), connected to said compressing means (20), for storing said compressed digital data.

8. An apparatus according to claim 7, characterized by said recorder (14) comprising; means (24), connected to said first memory (16), for decompressing said compressed digital data so as to generate output digital data; means, connected to said decompression means (24), for converting the output digital data into output analog data; and a speaker (28), connected to said output digital data converting means, for generating sound corresponding to the output analog data.

9. An apparatus according to claim 7, characterized by said computer (10) comprising a second memory (46) for storing the compressed digital data transferred from said recorder (16) to said computer (10), and means (18,42) for uploading the compressed digital data from the first memory (16) of the recorder (14) to the second memory (46) of the computer (10).
